(19) Europäisches Patentamt
European Patent Office
Office européen des brevets

(11) Veröffentlichungsnummer: **0 116 258**
**A2**

# (12) EUROPÄISCHE PATENTANMELDUNG

(21) Anmeldenummer: **83810424.8**

(22) Anmeldetag: **23.09.83**

(51) Int. Cl.³: **G 03 C 1/68**

(30) Priorität: **29.09.82 CH 5776/82**

(43) Veröffentlichungstag der Anmeldung:
**22.08.84 Patentblatt 84/34**

(84) Benannte Vertragsstaaten:
**BE CH DE FR GB IT LI NL SE**

(71) Anmelder: **CIBA-GEIGY AG**
**Postfach**
**CH-4002 Basel(CH)**

(72) Erfinder: **Tieke, Bernd, Dr.**
**Kaiser-Joseph-Strasse 268**
**D-7800 Freiburg(DE)**

(54) **Polymerisierbare Zusammensetzung, damit beschichtetes Material und dessen Verwendung.**

(57) Durch Strahlung polymerisierbare Zusammensetzungen auf der Basis von oberflächenaktiven konjugierten Diacetylenverbindungen der Formel $H(CH_2)_m-C{\equiv}C-C{\equiv}C-(CH_2)_n-A$ mit m und n = 0 oder 1 - 30 und m + n mindestens 10 und A = polarer Gruppe, die Mischungen solcher Diacetylenverbindungen enthalten oder mit oberflächenaktiven Substanzen gemischt sind, eignen sich besonders als photographisches Aufzeichnungsmaterial mit hoher Auflösung.

EP 0 116 258 A2

CIBA-GEIGY AG

Basel (Schweiz)

3-14108/+

Polymerisierbare Zusammensetzung, damit beschichtetes Material und dessen Verwendung

Die vorliegende Erfindung betrifft eine durch Strahlung polymerisierbare Zusammensetzung auf der Basis von oberflächenaktiven konjugierten Diacetylenverbindungen, ein mit dieser Zusammensetzung beschichtetes Material und dessen Verwendung als photographisches Aufzeichnungsmaterial.

Die Verwendung von durch Strahlung polymerisierbaren Substanzen hat bei der Herstellung von elektronischen und mikroelektronischen Bauteilen immer grössere Bedeutung erlangt. Die fortschreitende Verkleinerung der Bauteile bedingt auch die Einführung photosensitiver Substanzen, die in sehr dünnen Schichten auf Oberflächen aufgebracht werden können. Als geeignete Methode zur Herstellung monomolekularer Filme hat sich die Langmuir-Blodgett-Technik erwiesen, bei der oberflächenaktive und photopolymerisierbare Substanzen zunächst auf einer Wasseroberfläche aufgebracht und mittels Eintauchen des Substrates auf dieses übertragen werden. Bei Wiederholung dieses Verfahrens erhält man Mehrfachschichten. Für diese Technik geeignete Substanzen sind z.B. in der EP-A-0 022 618 beschrieben, in der oberflächenaktive Diacetylenverbindungen zur Beschichtung von Substraten offenbart sind. Durch Bestrahlung gegebenenfalls durch eine Bildmaske erhält man dann z.B. Passivierschichten bzw. photographische Abbildungen.

Die Diacetylenverbindungen bilden in den Schichten Bereiche einheitlicher Orientierung aus, die als Domänen bezeichnet werden.

Die Photopolymerisation erfolgt innerhalb der Domänen und nicht über deren Grenzen hinaus. Die Auflösung photographischer Abbildungen wird daher durch die Grösse der Domänen mitbestimmt.

Für photographische und photolithographische Systeme sind Auflösungen im Bereich von etwa 100 Å gewünscht. In der EP-A 0022618 wird vorgeschlagen, die aufgebrachten Schichten mit Domänengrössen mit bis zu 800 µm zunächst zu tempern, um eine Verkleinerung der Domänen und damit eine bessere Auflösung zu erreichen. Mit dieser unwirtschaftlichen Methode kann zwar im Durchschnitt eine Verkleinerung der Domänen erzielt werden, aber es wird eine breite Streuung von Bereichen mit bis zu ca. 100 µm beobachtet. Ausserdem wird die Verkleinerung durch eine Fehlordnung der Moleküle erreicht, die dadurch der Polymerisation entzogen werden, was den Polymerumsatz bei der Bestrahlung erheblich veringert und zu Fehlstellen in den polymerisierten Filmen führen kann.

Aufgabe vorliegender Erfindung ist es, eine durch Strahlung polymerisierbare Zusammensetzung auf der Basis von oberflächenaktiven konjugierten Diacetylenverbindungen bereitzustellen, die direkt in Schichten mit kleinen Domänenbereichen mit Grössen unter 20 µm und einer gleichmässigeren Grössenverteilung abgeschieden werden können und die keinen unerwünschten Rückgang des Polymerumsatzes bei der Bestrahlung zeigen.

Gegenstand vorliegender Erfindung ist eine durch Strahlung polymerisierbare Zusammensetzung auf der Basis von konjugierten Diacetylenverbindungen, enthaltend

a) eine Diinverbindung der Formel I

$$H(CH_2)_m-C\equiv C-C\equiv C-(CH_2)_n-A \qquad (I)$$

worin m und n unabhängig voneinander 0 oder eine ganze Zahl von 1 bis 30 sind und die Summe m + n mindestens 10 ist, wobei n mindestens gleich 1 ist, wenn die Gruppe A nicht über ein C-Atom an den Diinrest gebunden ist, und A eine polare Gruppe bedeutet, und

(b1) mindestens eine Verbindung der Formel I, die von (a) verschieden ist, (b2) ein Alkan mit 10 bis 30 C-Atomen, das durch eine polare Gruppe A substituiert sein kann oder (b3) einen oberflächenaktiven Farbstoff.

Vorzugsweise sind m und n unabhängig voneinander 0 oder eine Zahl von 1 bis 25. Besonders ist n eine Zahl von 0 bis 20. Insbesondere sind m und n Zahlen von 2 bis 16.

Die Gruppe A ist eine polare Gruppe, die den Verbindungen der Formel I hydrophile Eigenschaften verleiht, während der Kohlenwasserstoffrest gleichzeitig hydrophobe Eigenschaften bewirkt.

Bei der polaren Gruppe kann es sich z.B. um folgende Gruppen handeln: -SH, -OH, $-NR^1R^2$ (Amin), $-COOR^3$ (Carboxyl, Carboxylat), $-CONR^1R^2$ (Amide), $-OSO_3R^3$ (Sulfat), $-SO_3R^3$ (Sulfonat), $-OPO_2R^3R^4$ (Phosphit), $-OPO_3R^3R^4$ (Phosphat), $-PO_3R^3R^4$ (Phosphonat), -CN, Pyridyl oder Bipyridyl. Die Amingruppen können auch in Form quaternärer Ammoniumsalze vorliegen oder acyliert sein. $R^1$ und $R^2$ können unabhängig voneinander ein Wasserstoffatom, Alkyl oder Cycloalkyl und $R^1$ und $R^2$ zusammen Tetra- oder Pentamethylen oder 3-Oxapentylen sein. $R^3$ und $R^4$ können unabhängig voneinander ein Wasserstoffatom, ein Kation, Alkyl oder Cycloalkyl sein. Das Alkyl kann linear oder verzweigt sein und bis zu 18, vorzugsweise 1 bis 6 C-Atome enthalten. Das Cycloalkyl enthält bevorzugt 5 bis 7 Ring-C-Atome. Das Kation ist bevorzugt ein Alkali- oder Erdalkalikation oder ein Ammoniumkation. Bevorzugte Gruppen A sind -OH und $-COOR^3$.

Beispiele für Verbindungen der Formel I sind:

$n-C_{10}H_{21}-C\equiv C-C\equiv C-(CH_2)_6-A$

$n-C_{12}H_{25}-C\equiv C-C\equiv C-(CH_2)_8-A$

$n-C_{14}H_{29}-C\equiv C-C\equiv C-(CH_2)_{10}-A$

$n-C_{16}H_{33}-C\equiv C-C\equiv C-(CH_2)_4-A$

$n\text{-}C_{16}H_{33}\text{-}C\equiv C\text{-}C\equiv C\text{-}(CH_2)_2\text{-}A$
$n\text{-}C_{16}H_{33}\text{-}C\equiv C\text{-}C\equiv C\text{-}A$
$n\text{-}C_{10}H_{21}\text{-}C\equiv C\text{-}C\equiv C\text{-}(CH_2)_9\text{-}A$
$n\text{-}C_{12}H_{25}\text{-}C\equiv C\text{-}C\equiv C\text{-}(CH_2)_8\text{-}A$

wobei A vorzugsweise eine der zuvor definierten polaren Gruppen, besonders -OH oder -COOH ist.

Die Verbindungen der Formel I sind bekannt. Ihre Herstellung ist z.B. in J. of Poly. Science: Polymer Chemistry Edition, Vol. 17, 1631-1644 (1979) oder in der EP-A-0022 618 beschrieben oder sie können nach analogen Verfahren hergestellt werden.

Bei der Komponente (b1) der erfindungsgemässen Zusammensetzung kann es sich um isomere Verbindungen handeln; um solche, die sich in der Zahl m und/oder n unterscheiden und zusätzlich oder nur in der polaren Gruppe A.

Das Alkan der Komponente (b2) enthält bevorzugt 14 bis 24 C-Atome und ist insbesondere linear. Beispiele sind n-Tetradecan, n-Hexadecan, n-Octadecan, n-Eicosan. Sofern das Alkan durch eine polare Gruppe A substituiert ist, ist die polare Gruppe bevorzugt in Endstellung gebunden. Als polare Gruppe A kommen die zuvor beschriebenen Gruppen in Frage. Bevorzugt sind die gesättigten Fettsäuren und ihre Salze und Amide, die Alkohole und die Amine. Die Verbindungen der Komponente (b2) sind bekannt.

Verbindungen mit Pyridyl oder Bipyridyl als polare Gruppe A für die Komponenten b1 oder b2 können folgenden Formeln entsprechen:

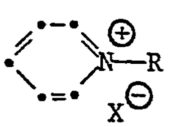 , 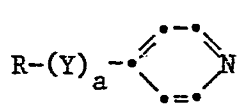 , 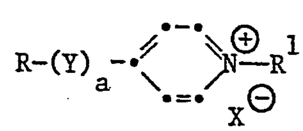 ,

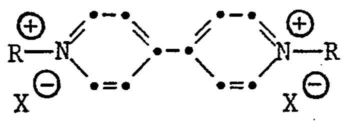 ,

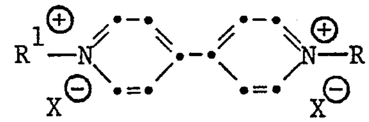 ,

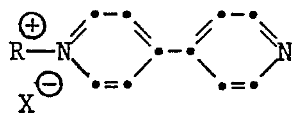

oder

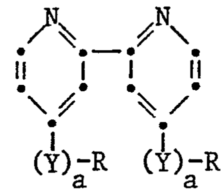 .

Hierin sind $X^{\ominus}$ ein Anion wie Chlorid, Jodid, Sulfat, Methylsulfat oder Tosylat; R ein wie zuvor definierter Diinrest oder Alkyl mit 10 bis 30 C-Atomen, $R^1$ ein wie zuvor definerter Rest, Y eine Brükkengruppe wie z.B. O, S, SO, $SO_2$, CO, $-CO_2-$ oder $-NR^1-$ und a ist 0 oder 1.

Als Komponente (b3) sind alle Farbstoffe geeignet, die durch eine oder mehr längerkettige, vorzugsweise lineare Alkylgruppen substituiert sind. Die Alkylgruppe weist vorzugsweise mindestens 10 C-Atome auf und kann z.B. Decyl, Undecyl, Dodecyl, Tetradecyl, Hexadecyl, Octadecyl oder Eicosyl sein. Geeignete Farbstoffe sind dem Fachmann geläufig und ebenso Methoden zur Einführung der Alkylgruppen in das Farbstoffmolekül.

Als Beispiele seien folgende Farbstoffe angeführt:

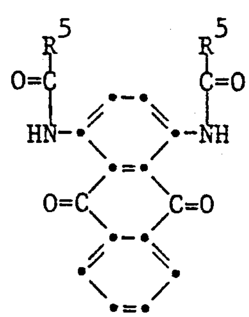

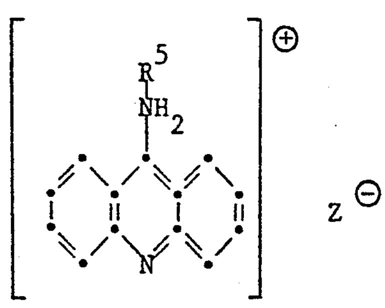

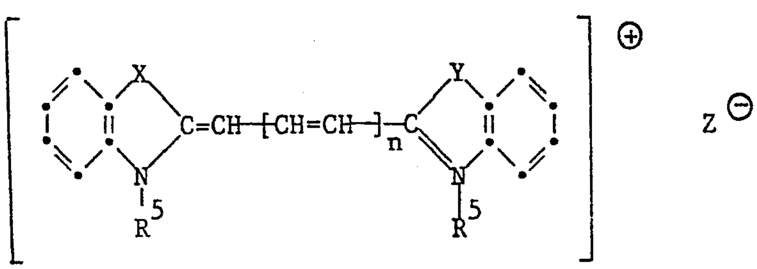

worin $R^5$ vorzugsweise lineares Alkyl mit 10 bis 30, besonders 12 bis 20 C-Atomen ist, X und Y für O, S oder Se stehen und Z ein Anion bedeutet, wie z.B. Cl, Br, J oder $ClO_4$.

Bevorzugt sind Mischungen mit den Komponenten (a) und (b1) und soche mit den Komponenten (a) und (b3). Beispiele hierfür sind:

Tricosa-10,12-diinsäure/Tricosa-4,6-diinsäure
Pentacosa-10,12-diinsäure/Pentacosa-4,6-diinsäure
Pentacosa-10,12-diinsäure/N,N'-Distearyl-1,4-diaminoanthrachinon.

Die mengenmässige Zusammenstezung der Komponenten (a) und (b1) kann 1 bis 99 Gew.-%, vorzugsweise 5 bis 95 Gew.-% und insbesondere 10 bis 90 Gew.-% der Komponente (a) und 99 bis 1 Gew.-%, vorzugsweise 95 bis 5 Gew.-% und insbesondere 90 bis 10 Gew.-% der Komponente (b1) betragen. Weiter können 10 bis 90 Gew.-%, vorzugsweise 50 bis 90 Gew.-% Komponente (a) und 90 bis 10 Gew.-%, vorzugsweise 50 bis 10 Gew.-% der Komponente (b2) zugegen sein. Das Mengenverhältnis der Komponenten (a) und (b3) beträgt bevorzugt 99 bis 80, Gew.-%, besonders 99 bis 90 Gew.-% der Komponente (a) und 1 bis 20 Gew.-%, besonders 1 bis 10 Gew.-% der Komponente (b3).

Die erfindungsgemässe Zusammensetzung kann weitere übliche Zusätze enthalten, wie z.B. Haftmittel, Sensibilisatoren, Photoinitiatoren, Farbstoffe, Pigmente und Füllstoffe.

Die erfindungsgemässen Zusammensetzungen können durch Strahlung polymerisiert werden, z.B. durch Elektronenstrahlen, Laserstrahlung, Röntgenstrahlung und besonders UV-Strahlung. Sie eignen sich daher zur Herstellung von Schutzüberzügen auf Substraten, als photographisches Abbildungsmaterial, Photoresist, zur Informationsspeicherung, als Bauteile für die Mikroelektronik und integrierte Optik, Wellenleiter, Frequenzvervielfacher.

Die Zusammensetzung kann hierbei mittels üblichen Methoden gegebenenfalls als Lösung in üblichen Lösungsmitteln wie z.B. halogenierten

Kohlenwasserstoffen, wie Tauchen, Rollen, Sprühverfahren, Vorhanggiessverfahren auf mindestens eine Oberfläche von Substraten aufgebracht werden. Die Schichtdicken können bis zu 50 µm und mehr betragen. Geeignete Substrate sind z.B. Halbleiter, Metalle, kupferkaschierte Platten, Kunststoffe, Glas, Quarz und Keramik. Die Oberflächen können zur besseren Haftung mit Haftvermittlern ausgerüstet sein.

Ein besonders geeignetes Verfahren zum Aufbringen der erfindungsgemässen Zusammensetzungen ist die Langmuir-Blodgett-Methode, die z.B. in der EP-A-0 022 618 beschrieben ist. Mit diesem Verfahren werden monomolekulare Schichten auf den Oberflächen der Substrate abgeschieden. Die fortschreitende Wiederholung eines Verfahrensschrittes führt zur Abscheidung mehrer Schichten und es können 40 Schichten und mehr aufgebracht werden. Der Vorteil der Methode liegt im Aufbringen gleichmässiger und definierter Schichtdicken.

Ein weiterer Gegenstand vorliegender Erfindung sind Substrate mit einer dünnen Schicht der erfindungsgemässen Zusammensetzung auf mindestens einer Oberfläche. Bevorzugt ist deren Verwendung für photographische Abbildungen.

Es wurde überraschend gefunden, dass die erfindungsgemässen Zusammensetzungen auf den Substratoberflächen direkt unter Ausbildung kleiner und gleichmässiger Domänen abgeschieden werden, die unter 20 µm gross sind. Es können sogar Grössen im µ-Bereich erzielt werden. Mit der Verwendung der beschichteten Substrate als photographisches Aufzeichnungsmaterial werden daher hohe Auflösungen erzielt bis zu einem Bereich von 100 Å. In manchen Fällen, besonders bei Verwendung langkettiger Carbonsäuren wie z.B. Eladinsäure oder Stearinsäure, wird die Bildung von Ueberstrukturen beobachtet, die zu Kristalliten einer Grösse bis in den cm-Bereich führen, ohne jedoch die gewünschten Eigenschaften negativ zu beeinflussen.

Die erfindungsgemässe Zusammensetzung weist noch weitere Vorteile auf. Mit der Zugabe der Komponente (b1) ist eine erhöhte Reaktivität bei der Bestrahlung verbunden und das Polymerisat weist eine wesentlich höhere optische Dichte (gleich tiefere Farbe) auf. Die Zugabe von Komponente (b2), besonders solche mit polarer Kopfgruppe, bewirken eine erhöhte Stabilität des monomolekularen Filmes auf der Wasseroberfläche bei der Langmuir-Blodgett-Methode, was höhere Tauchgeschwindigkeiten der Substrate erlaubt. Mit der Zugabe der Komponente (b3), besonders oberflächenaktive Farbstoffe mit Doner- oder Akzeptoreigenschaften, wird eine zusätzliche Sensibilisierung der Photopolymerisation im Bereich der Farbstoffabsorption erzielt.

Die nachfolgenden Beispiele erläutern die Erfindung näher.

Beispiel 1: Mischung zweier isomerer Diacetylenfettsäuren. Tricosa-10,12-diinsäure-1 und Tricosa-4,6-diinsäure-1 werden im Molverhältnis 10:4 in Chloroform gelöst, in einer Gesamtkonzentration von 1 mg/ml. Diese Lösung wird bei 15°C auf einer wässrigen $CdCl_2$-Lösung (Konzentration: 3x $10^{-4}$ mol/l) mit einem pH-Wert von 7 gespreitet. Der erhaltene monomolekulare Film wird bis zu einem Filmdruck von 20mN/m komprimiert. Dann wird eine Quarzplatte, die mit 3 Schichten Cadmiumarachidat vorbeschichtet ist, einmal senkrecht ins Wasser ein- und wieder ausgetaucht. Anschliessend wird die Probe 45 min mit einer UV-Lampe (6 W-Quecksilber-Niederdruck-lampe) bestrahlt. Die Bildung des Polymeren wird absorptions-spektroskoptisch nachgewiesen (Spektrometer: Perkin-Elmer Hitachi 200) und die Grösse der Domänen im Polarisationsmikroskop (Zeiss Photomikroskop III) bestimmt.

In Tabelle 1 sind die optische Dichte des Polymeren, die ein Mass für den erreichten Umsatz darstellt, sowie die Domänengrössen angegeben.

Beispiel 2: Mischung zweier oberflächenaktiver Diacetylene mit mit verschiedenen polaren Kopfgruppen.

Pentacosa-10,12-diinsäure-1 und Pentacosa-10,12-diinol-1 werden im Molverhältnis 10:3 in Chloroform in einer Gesamtkonzentration von 1 mg/ml gelöst. Die Schicht wird wie in Beispiel 1 hergestellt und polymerisiert.

Die optische Dichte des Polymeren und Domänengrössen sind in Tabelle 1 angegeben.

Beispiel 3: Mischung einer Diacetlyenfettsäure und einem gesättigten Alkan.

Pentacosa-10,12-diinsäure und n-Octadecan werden im Molverhältnis 10:3 in Chloroform gelöst in einer Gesamtkonzentration von 1 mg/ml. Die Schicht wird wie in Beispiel 1 hergestellt und polymerisiert. Die optische Dichte der polymerisierten Probe sowie die Domänengrösse sind in Tabelle 1 angegeben.

Beispiel 4:Mischungen von Diacetylenfettsäure und oberflächenaktivem Farbstoff.

Pentacosa-10,12-diinsäure und Bis-[3-stearyl-benzoselenazol-(2)]-trimethincyanin-jodid werden im Molverhältnis 100:3 in Chloroform gelöst in einer Gesamtkonzentration von 1 mg/ml. Die Schicht wird wie in Beispiel 1 hergestellt. Die Polymerisation erfolgt mit einer 200 W Quecksilber-Mitteldrucklampe mit Interferenzfilter $\lambda$= 579 nm.

Die optische Dichte des Polymeren und Domänengrösse sind in Tabelle 1 angegeben.

Tabelle 1

| Beispiel Nr. | Domänengrösse [μm] (Länge x Breite) | Optische Dichte (λ max) |
|---|---|---|
| 1 | 1 x 1 bis 5 x 1 | 0,028 (545) |
| 2 | 0,6 x 1 | 0,027 (640) |
| 3 | 1 x 1 bis 8 x 2 | 0,015 (640) |
| 4 | 3 x 15 | 0,010 (640) |

Beispiel 5: Gemäss Beispiel 3 werden folgende Mischungen (Molverhältnis 10:4) in Chloroform gelöst, eine Quarzplatte beschichtet und die Schicht polymerisiert:

Tricosa-10,12-diinsäure/Stearinsäure
Tricosa-10,12-diinsäure/Eladinsäure
Tricosa-10,12-diinsäure/Arachinsäure

Man erhält Schichten mit Domänengrössen im Bereich von 1-10 μm.

Ansprüche

1) Durch Strahlung polymerisierbare Zusammensetzung auf der Basis von konjugierten Diacetylenverbindungen, enthaltend

a) eine Diinverbindung der Formel I

$$H(CH_2)_m-C\equiv C-C\equiv C-(CH_2)_n-A \qquad (I)$$

worin m und n unabhängig voneinander 0 oder eine ganze Zahl von 1 bis 30 sind und die Summe m + n mindestens 10 ist, wobei n mindestens gleich 1 ist, wenn die Gruppe A nicht über ein C-Atom an den Diinrest gebunden ist, und A eine polare Gruppe bedeutet, und

(b1) mindestens eine Verbindung der Formel I, die von (a) verschieden ist, (b2) ein Alkan mit 10 bis 30 C-Atomen, das durch eine polare Gruppe A substituiert sein kann oder (b3) einen oberflächenaktiven Farbstoff.

2) Zusammensetzung gemäss Anspruch 1, dadurch gekennzeichnet, dass m und n unabhängig voneinander 0 oder eine Zahl von 1 bis 20 bedeuten.

3) Zusammensetzung gemäss Anspruch 1, dadurch gekennzeichnet, dass die polare Gruppe A -SH, -OH, $-NR^1R^2$, $COOR^3$, $CONR^1R^2$, $-OSO_3R^3$, $-SO_3R^3$, $-OPO_2R^3R^4$, $-OPO_3R^3R^4$, $-PO_3R^3R^4$, Pyridyl oder Bipyridyl ist, worin $R^1$ und $R^2$ ein Wasserstoffatom, Alkyl oder Cycloalkyl und $R^1$ und $R^2$ zusammen Tetra- oder Pentamethylen oder 3-Oxapentylen bedeuten und $R^3$ und $R^4$ für ein Wasserstoffatom, ein Kation, Alkyl oder Cycloalkyl stehen.

4) Zusammensetzung gemäss Anspruch 1, dadurch gekennzeichnet, dass sie 99-1 Gew.-% der Komponente (a) und 1 - 99 Gew.-% der Komponente (b1) enthält, bezogen auf die Zusammensetzung.

5) Zusammensetzung gemäss Anspruch 1, dadurch gekennzeichnet, dass sie 10 bis 90 Gew.-% der Komponente (a) und 90 bis 10 Gew.-% der Komponenten (b1) oder (b2) oder 80 bis 99 Gew.-% der Komponente (a) und 1 bis 20 Gew.-% der Komponente (b3) enthält.

6) Zusammensetzung gemäss Anspruch 1, dadurch gekennzeichnet, dass das Alkan (b2) linear ist und sich die polare Gruppe A in Endstellung befindet.

7) Zusammensetzung gemäss Anspruch 1, dadurch gekennzeichnet, dass es sich bei dem Farbstoff (b3) um einen solchen handelt, der mindestens eine Alkylgruppe mit mindestens 10 C-Atomen enthält, die an ein chromophores Molekül gebunden ist.

8) Zusammensetzung gemäss Anspruch 1, dadurch gekennzeichnet, dass sie eine Mischung aus Tricosa-10,12-diinsäure/Tricosa-4,6-diinsäure, Pentacosa-10,12-diinsäure/Pentacosa-4,6-diinsäure oder Pentacosa-10,12-diinsäure/N,N'-Distearyl-1,4-diaminoanthrachinon enthält.

9) Ein Material aus einem Substrat, auf dessen Oberfläche eine dünne Schicht einer Zusammensetzung gemäss Anspruch 1 aufgebracht ist.

10) Material gemäss Anspruch 8, bei dem die Schicht bis zu 50 µm dick ist.

11) Verwendung des Materials gemäss Anspruch 8 zur Herstellung von Schutzschichten oder als photographisches Aufzeichnungsmaterial.